# EUROPÄISCHE PATENTSCHRIFT

(11) **EP 2 699 711 B1**
(45) Veröffentlichungstag und Bekanntmachung des Hinweises auf die Patenterteilung: **04.03.2015**
(21) Anmeldenummer: 12724070.3
(22) Anmeldetag: 30.03.2012
(51) Int. Cl.: C23C 16/24, C23C 16/32, C23C 16/448, H01L 21/02

(54) **HEISSDRAHTVERFAHREN ZUR ABSCHEIDUNG VON HALBLEITER-MATERIAL AUF EINEM SUBSTRAT UND VORRICHTUNG ZUR DURCHFÜHRUNG DES VERFAHRENS**
HOT-WIRE METHOD FOR DEPOSITING SEMICONDUCTOR MATERIAL ON A SUBSTRATE AND DEVICE FOR PERFORMING THE METHOD
PROCÉDÉ À FIL CHAUD POUR LE DÉPÔT DE MATÉRIAU SEMI-CONDUCTEUR SUR UN SUBSTRAT ET DISPOSITIF DE MISE EN OEUVRE DE CE PROCÉDÉ

(30) Priorität: 20.04.2011 DE 102011018324
(43) Veröffentlichungstag der Anmeldung: 26.02.2014
(73) Patentinhaber: Forschungszentrum Jülich GmbH, 52425 Jülich (DE)
(72) Erfinder: FINGER, Friedhelm, 52428 Jülich (DE); SCHMALEN, Andreas, 52393 Hürtgenwald (DE); WOLFF, Johannes, 52379 Langerwehe (DE)
(86) Internationale Anmeldenummer: PCT/DE2012/000346
(87) Internationale Veröffentlichungsnummer: WO 2012/142992

(56) Entgegenhaltungen:
- WO-A2-2011/034751
- JP-A- 2004 091 821
- US-A1- 2011 033 638
- TAO CHEN ET AL: "Microcrystalline silicon thin film solar cells with microcrystalline silicon carbide window layers and silicon absorber layers both prepared by Hot-Wire CVD", PHYSICA STATUS SOLIDI (RRL) - RAPID RESEARCH LETTERS, Bd. 4, Nr. 3-4, 1. April 2010 (2010-04-01) , Seiten 61-63, XP55033138, ISSN: 1862-6254, DOI: 10.1002/pssr.200903423
- YAE ET AL: "Solar to chemical conversion using metal nanoparticle modified microcrystalline silicon thin film photoelectrode", SOLAR ENERGY MATERIALS AND SOLAR CELLS, ELSEVIER SCIENCE PUBLISHERS, AMSTERDAM, NL, Bd. 91, Nr. 4, 10. Dezember 2006 (2006-12-10), Seiten 224-229, XP005882122, ISSN: 0927-0248, DOI: 10.1016/J.SOLMAT.2006.08.010
- OGAWA ET AL: "Amorphous Si1-xCx:H films prepared by hot-wire CVD using SiH3CH3 and SiH4 mixture gas and its application to window layer for silicon thin film solar cells", THIN SOLID FILMS, ELSEVIER-SEQUOIA S.A. LAUSANNE, CH, Bd. 516, Nr. 5, 15. Januar 2008 (2008-01-15), Seiten 758-760, XP022492173, ISSN: 0040-6090, DOI: 10.1016/J.JCIS.2007.12.013
- OGAWA ET AL: "Applications of microcrystalline hydrogenated cubic silicon carbide for amorphous silicon thin film solar cells", THIN SOLID FILMS, ELSEVIER-SEQUOIA S.A. LAUSANNE, CH, Bd. 516, Nr. 5, 15. Januar 2008 (2008-01-15), Seiten 740-742, XP022492168, ISSN: 0040-6090, DOI: 10.1016/J.TSF.2007.06.047

## Beschreibung

Die Erfindung betrifft ein Heißdrahtverfahren zur Abscheidung von Halbleiter-Material auf einem Substrat und eine Vorrichtung zur Durchführung des Verfahrens.

Beim Heißdraht (HWCVD)-Verfahren (engl. Hot Wire Chemical Vapor Deposition) wird ein Gasgemisch mittels eines erhitzten Drahtes in Substratnähe in Fragmente zerlegt. Ein Zersetzungsprodukt scheidet sich auf dem Substrat ab. Über die Auswahl und das Mischungsverhältnis der eingesetzten Gassorten ist die chemische Zusammensetzung der Schichten sehr gut einstellbar.

Bei der Herstellung von Halbleiterschichten, wie mikrokristallines Silizium (µc-Si:H) und Silizium-Kohlenstoff (µc-SiC:H), mit dem Heißdrahtverfahren ist die Auswahl des DrahtMaterials für die Qualität der Schichten sowie für die Stabilität der Drähte während des Prozesses bzw. über längere Betriebsdauer von entscheidender Bedeutung. Es wurde gefunden, dass für die Herstellung von µc-Si:H Tantal (Ta) das am besten geeignete Material ist. Für die Herstellung von µc-SiC:H wurde Rhenium (Re) als bestes Material gefunden. Mit Rhenium lässt sich auch µc-Si:H herstellen, allerdings führt eine abwechselnde Deposition von µc-Si:H und µc-SiC:H zur Zerstörung der Rhenium-Drähte.

Aus T. Chen, Y. Huang, D. Yang, R. Carius und F. Finger, Physica Status Solidi RRL 4, No. 3-4, 61-63 (2010) ist ein Heißdrahtverfahren zur Abscheidung von Halbleiterschichten auf einem Substrat bekannt, bei dem das Substrat zwischen zwei Vakuum-Kammern bewegt wird, wobei diese Kammern mit Drähten aus verschiedenen Materialien für die Abscheidung der unterschiedlichen Halbleiterschichten bestückt sind.

Nachteilig ist die Abscheidung mehrerer Halbleiter-Schichten in einer Heißdraht (HWCVD)-Kammer mit einem schnellen Verfahren nicht möglich.

Aufgabe der Erfindung ist es ein Heißdraht (HWCVD)-Verfahren bereit zu stellen mit dem Halbleiter-Schichten schnell abgeschieden werden können sowie eine Vorrichtung zur Durchführung des Verfahrens anzugeben.

Die Aufgabe wird gelöst nach dem Verfahren nach Patentanspruch 1 und durch die Vorrichtung zur Durchführung des Verfahrens gemäß Nebenanspruch. Vorteilhafte Ausgestaltungen hierzu ergeben sich jeweils aus den hierauf rückbezogenen Patentansprüchen.

Das Heißdrahtverfahren wird zur Abscheidung von Halbleiter-Materialien auf einem Substrat in einer Abscheidungskammer durchgeführt. Dabei werden mindestens zwei Drähte an ihren Enden in eine Drahthalterung in der Kammer geklemmt. Das Anlegen einer Spannung erfolgt zur Aufheizung der Drähte und damit zur thermischen oder katalytischen Zersetzung von Vorläuferverbindungen und Abscheidung der gewünschten Halbleiter auf dem Substrat. Die Drähte aus verschiedenem Material werden dabei vorteilhaft zeitlich nacheinander an eine Spannungsquelle angeschlossen und unter Strom gesetzt, so dass eine der Anzahl der nacheinander erhitzten Drahtmaterialien entsprechende Anzahl an verschiedenen Halbleitern nacheinander auf dem Substrat abgeschieden werden ohne die Kammer zu öffnen.

Im Rahmen der Erfindung wurde erkannt, dass die Abscheidung von unterschiedlichen Schichten im Stand der Technik nur nach aufwendigem Wechsel des Drahtmaterials in der Abscheidungskammer möglich ist. Der Wechsel des Drahtmaterials erfordert das Öffnen der Abscheidungskammer, einen Austausch der teuren Drähte, sowie weiteren Zeitverlust beim Einfahren des neuen Drahts. Alternativ werden jeweils einzelne Kammern die mit unterschiedlichen Drähten bestückt sind für jeden Abscheidungsprozess benötigt, was aber nachteilig die Entnahme und Überführung des beschichteten Substrats von einer Kammer in eine andere Kammer zur weiteren Beschichtung erfordert. Auch diese Maßnahme führt also zu Zeitverlusten.

Es werden erfindungsgemäß mindestens zwei Drähte aus verschiedenen Materialien an ihren Enden in Drahthalterungen gespannt und geklemmt. Die Drähte werden zeitlich nacheinander durch Stromzufuhr und Anschluss an eine oder mehrere Spannungsquellen unter Strom gesetzt. Dadurch wird vorteilhaft bewirkt, dass nur das jeweilige zur Abscheidung eines Halbleiters benötigte Drahtmaterial aufgeheizt wird und nach der Abscheidung des Materials der andere Draht elektrisch angesteuert wird, so dass mindestens zwei Halbleiter-Materialien zeitlich nacheinander abgeschieden werden ohne die Kammer zu öffnen. Das Anlegen der Spannung erfolgt zur Zersetzung von sogenannten Vorläuferverbindungen die gasförmig an die Drähte herangeführt werden. Die Verbindung dissoziiert in Fragmente.

Die Fragmente reagieren gegebenenfalls mit weiteren Fragmenten oder Vorläuferverbindungen bevor sie auf dem Substrat abgeschieden werden.

Vorteilhaft wird auf diese Weise eine schnelle kostengünstige Abscheidung verschiedener Halbleiter-Materialien nacheinander auf dem Substrat bewirkt.

In einer Ausgestaltung der Erfindung wird eine Drahthalterung gewählt, die mindestens zwei elektrisch voneinander isolierte Stromzuführungen für mindestens zwei verschiedene Drahtmaterialien aufweist. Jede Stromzuführung bewirkt vorteilhaft die Erhitzung eines Drahtes bzw. mehrerer Drähte aus einem Material und dadurch die Zersetzung einer Vorläuferverbindung sowie die Abscheidung des gewünschten Halbleiters entlang der erhitzten Drähte.

Besonders vorteilhaft werden über jede Stromzuführung mehrere Drähte aus dem gleichen Material gleichzeitig erhitzt. Die Stromzuführung für die Erhitzung von Drähten einer Drahtsorte hat Verteilerfunktion.

Dadurch wird vorteilhaft bewirkt, dass mehr Halbleiter-Material auf einer größeren Substratfläche entlang der gleichzeitig erhitzten Drähte einer Sorte abgeschieden werden kann.

Besonders vorteilhaft wird Rhenium und Tantal als Material der mindestens zwei verschiedenen Drähte in die Vorrichtung geklemmt. Dadurch wird vorteilhaft bewirkt, dass reproduzierbar, dauerhaft und über viele Depositionsvorgänge hinweg µc-Si:H und µc-SiC:H Halbleiterschichten hergestellt werden können ohne dass die Drahtmaterialien nachteilig beschädigt werden und ohne die Kammer zu öffnen.

Besonders vorteilhaft kann während des Verfahrens abwechselnd µc-Si:H und µc-SiC:H mit dem Tantaldraht bzw. Rheniumdraht abgeschieden werden ohne dass die Heissdrahtkammer geöffnet werden muss um Drähte auszutauschen. Dabei werden als Ausgangssubstanzen die Gase Silan (SiH₄) und Wasserstoff (H₂) für die Herstellung von µc-Si:H und die Gase Monomethylsilan (H₃Si-CH₃) und H₂ für die Herstellung von µc-SiC:H eingesetzt. Für Dotierung werden die Gase Phosphin (PH₃), Diboran (B₂H₆), Trimethylbor (B(CH₃)₃) und Trimethylaluminium (Al₂(CH₃)₆) eingesetzt.

Die Vorrichtung zur Durchführung des Heißdraht (HWCVD)-Verfahrens ist durch eine Drahthalterung für die Aufnahme mindestens zweier unterschiedlicher Drähte gekennzeichnet, die die Drähte eines ersten Materials gleichzeitig an einen anderen Stromkreis anbindet als die Drähte eines zweiten oder dritten und so weiter, Materials.

Der oder die Drähte einer Materialsorte werden mittels des Drahthalters an einen bestimmten Stromkreis angebunden.

Mit mindestens zwei Drähten ist also gemeint, dass die Halterung mindestens zwei Drähte unterschiedlichen Materials halten kann. Es können auch zwei, drei oder mehr Drähte gleichen Materials neben oder zwischen zwei, drei oder mehr Drähten aus einem anderen Material angeordnet sein, z. B. in einer alternierenden, abwechselnden Art und Weise. Es können auch in alternierender Weise noch mehr Drähte unterschiedlichen Materials in der Drahthalterung gehalten werden, wobei immer die Drähte aus dem gleichen Material an einen bestimmten Stromkreis bzw. an eine Stromquelle gleichzeitig angebunden sind. Hierdurch wird vorteilhaft bewirkt, dass nur die Drähte eines bestimmten Materials gleichzeitig erhitzt werden, wohingegen die Drähte aus den übrigen Materialien zu diesem Zeitpunkt nicht erhitzt werden. Wenn der Halbleiter abgeschieden ist, werden der oder die Drähte aus einem zweiten Material erhitzt und der für diese Abscheidung vorgesehene Halbleiter abgeschieden. Hierdurch wird vorteilhaft bewirkt, dass nur immer ein bestimmter Halbleiter auf dem Substrat abgeschieden wird, indem das entsprechende Drahtmaterial zur Dissoziation der Vorläuferverbindung für diesen Halbleiter erhitzt wird.

Die Vorrichtung weist vorteilhaft eine Drahthalterung aus zwei Halteblöcken für die Aufnahme der Enden von parallel zueinander ausgerichteten Drähten auf. Die Halteblöcke bestehen vorteilhaft aus Keramik oder einem anderen elektrisch isolierenden, strom- und vakuumfesten Material. Dadurch wird vorteilhaft bewirkt, dass die Drähte in den parallel zueinander ausgerichteten Stirnseiten der keramischen Halterungen geklemmt werden können, ohne dass die Stromzuführungen und Anschlüsse sich gegenseitig elektrisch beeinflussen, da die Keramik von sich aus als Isolator wirkt. Das Material kann vorzugsweise aus Macor^{™} bestehen. MACOR besteht etwa aus: 46% SiO₂, 17% MgO, 16% Al₂O₃, 10% K₂O, 7% B₂O₃ und 4% F.

Die Halteblöcke umfassen mindestens zwei Strom leitende Schienen als Stromzuführungen. Die Stromschienen werden z. B. auf einem Halteblock montiert und sind Bestandteil unterschiedlicher Stromkreise bzw. werden nacheinander von einer Stromquelle, möglicherweise auch derselben Stromquelle kontaktiert. Jede Stromschiene steht mit den Drähten einer bestimmten Materialsorte in elektrischem Kontakt und verteilt den Strom der Stromquelle auf diese Drähte. Jede Schiene ist daher für die Erhitzung der Drähte eines bestimmten Materials und damit zur Erhitzung des Drahts oder der Drähte für die Abscheidung eines bestimmten Halbleiters vorgesehen. Jede Stromschiene steht mit einer Stromquelle und den Drähten in elektrischem Kontakt, bzw. verteilt den Strom aus dieser Stromquelle an die Drähte desselben Materials.

Eine Strom leitende Schiene kontaktiert somit die Drähte aus identischem Material, so dass vorteilhaft ein bestimmter Halbleiter aus dem in die Kammer eingeleiteten Vorläufergas dissoziiert und über eine größere Fläche entsprechend der Aufspannung der Drähte über dem Substrat hierauf abgeschieden werden kann. Es kann auch nur ein einziger Draht aus einem bestimmten Material über eine Stromschiene kontaktiert werden.

Besonders vorteilhaft weist die Drahthalterung entlang der Drähte auch Gaszuführungen auf. Die Halteblöcke weisen hierzu neben den Stromschienen und den Klemmen für die Drähte hierzu parallel angeordnete Klemmen für die Gaszuführungen auf. Die Gaszuführungen sind z. B. röhrförmig mit Austrittslöchern unterhalb der Drähte in den Halteblöcken angeordnet. Auf diese Weise wird vorteilhaft bewirkt, dass das Gas gezielt an die Drähte geführt wird und zu Einsparungen im Verbrauch führt.

So können die Halteblöcke z. B. vorteilhaft insgesamt sechs Klemmen für das alternierende Klemmen von jeweils drei Drähten aus demselben Material aufweisen. Erst wird beispielweise der erste Draht der Sorte eins an seinen Enden in den beiden Halteblöcken geklemmt und damit zwischen den Halteblöcken aufgespannt. Sodann folgt ein Draht der Sorte zwei. Sorte eins kann ein Draht aus Rhenium, und Sorte zwei ein Draht aus Tantal sein. Dann folgt wieder ein Draht der Sorte eins und sodann erneut ein Draht der Sorte zwei. Dieses abwechselnde Positionieren von Drähten der mindestens zwei Sorten führt besonders vorteilhaft zur gleichmäßigen Erhitzung des Gasvolumens einer Heißdrahtkammer über dem Substrat.

Es können selbstverständlich mehr als zwei Sorten an Drähten abwechselnd zwischen den Halteblöcken der Vorrichtung angeordnet werden. Dann benötigen die Halteblöcke mindestens eine der Anzahl der verwendeten Drahtsorten entsprechende Anzahl an Stromzuführunggen.

Stromschienen als Stromzuführungen können hierzu auf den Halteblöcken angeordnet sein. Diese werden mit der Stromversorgung der Heißdrahtkammer so verbunden, dass die Drähte eines Materials (Drahtsorte 1) separat nacheinander von den Drähten eines zweiten Materials (Drahtsorte 2) angesteuert werden. Dadurch wird vorteilhaft bewirkt, dass nur Drähte einer Sorte unter Strom gesetzt und erhitzt werden, wogegen die andere(n) Drahtsorte(n) nicht in Betrieb ist bzw. sind.

Eine erfindungsgemäße Heißdrahtkammer zur Durchführung des Verfahrens nach einem der vorhergehenden Ansprüche, ist gekennzeichnet durch Drahthalterungen zur Aufnahme der zwei Drähte an den Enden, wobei die Drahthalterung mindestens zwei separate Stromkreise zum Anschließen an die mindestens zwei Stromkreise der Heißdrahtkammer aufbauen kann.

Im Weiteren wird die Erfindung an Hand von einem Ausführungsbeispiel näher erläutert, ohne dass es hierdurch zu einer Beschränkung der Erfindung kommen soll.
Figur 1 zeigt die erfindungsgemäße Heißdraht (HWCVD)-Abscheidungskammer im Querschnitt.
Figur 2 zeigt den erfindungsgemäßen Aufbau einer Vorrichtung zur Durchführung des Heißdraht (HWCVD)-Verfahrens als Explosionszeichnung.
Figur 3 zeigt Figur 2 als erfindungsgemäßen Aufbau nebst der Drahthalterung und der Gaszufuhren sowie den Anschlüssen an die Stromkreise über die beiden Stromschienen je Halteblock.

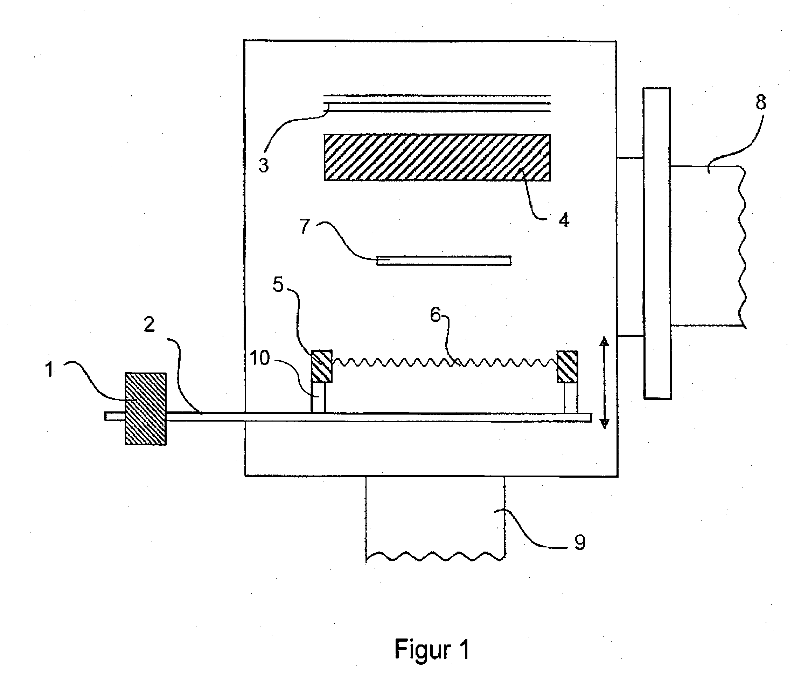

In Figur 1 ist die erfindungsgemäße Abscheidungskammer gezeigt. Über das Haupt-Gasventil 1 wird Gas in die Kammer über die Gaszuführung 2 geleitet. Unterhalb der Drahthalterung 5 aus zwei Halteblöcken strömt das Gas an den Drähten 6 in die Kammer. Das Substrat 7 ist parallel zu den Drähten 6 in der Kammer angeordnet. Der Heizer 4 für das Substrat 7 erhitzt dieses. Hitzebleche 3 schirmen die Kammer vor dem Heizer 4. Die Kammer wird durch das Pumpsystem 9 und die Roboterkammer 8 vervollständigt.

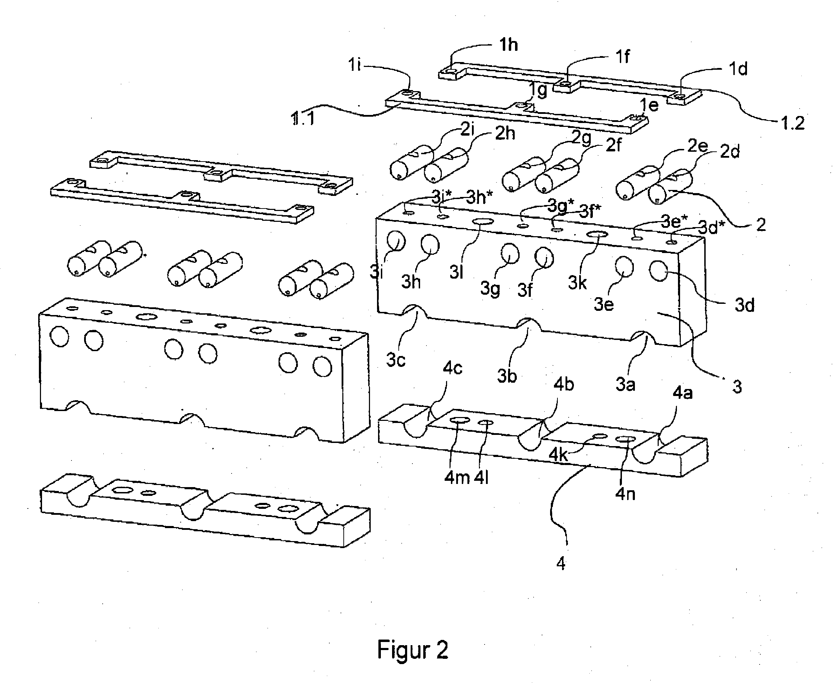

Figur 2 zeigt die erfindungsgemäße Vorrichtung zur Durchführung des erfindungsgemäßen Verfahrens in einer Explosionszeichnung. Die erfmdungsgemäße Drahthalterung umfasst jeweils zwei Halteblöcke 3, 4 nebst Stromschienen 1.1 und 1.2 sowie die Drahthaltehülsen 2.

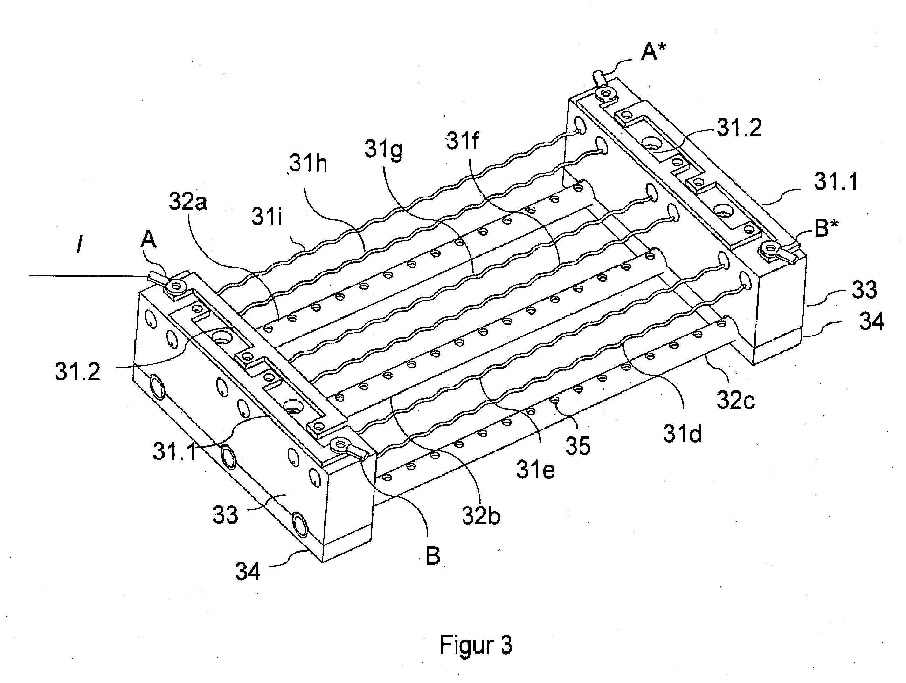

Jeder der beiden Halteblöcke 3, 4 besteht aus einem oberen keramischen Grundkörper 3 und einen unteren keramischen Flachkörper 4. Der obere und der untere Körper werden über Schrauben und die Löcher 4k an 3k und 41 an 31 zusammengeschraubt. Der Haltekörper 3 und der Flachkörper 4 sind im zusammengebauten Zustand aneinander gepresst, so dass sich die halbrunden Öffnungen 3a an 4a und 3b an 4b und 3c an 4c zu je einer kreisrunden Klemmhalterung für je eine Gaszuführung zusammenschließen (siehe Figur 3).

Die Drähte werden wie folgt gehalten: Die Stromschienen 1.1 und 1.2 werden ineinandergreifend ohne sich zu berühren auf die Drahthalterung 3 aufgesetzt, so dass die Löcher 1e, 1g und 1i der Stromschiene 1.1 auf den Löchern 3e*, 3g*, und 3i* des Grundkörpers 3 aufliegen. Die Drahthaltehülsen 2 (nur die ganz rechte Hülse ist mit Bezugszeichen 2 gekennzeichnet) werden so in die Löcher 3d bis 3i der Drahthalterung eingeführt, dass die Löcher 2d, 2e, 2f, 2g, 2h und 2i der Drahthaltehülsen 2 sowie die Löcher 1e, 1g und 1i der Stromschiene 1.1 sowie die Löcher 1d, 1f und 1h der Stromschiene 1.2 sowie die Löcher 3d* bis 3i* übereinander zur Verschraubung der Teile mit den Drähten positioniert werden.

Schrauben werden hierzu in die Löcher 1d bis 1i der Stromschienen 1.1 und 1.2 eingeführt und klemmen die Stromschienen an die Halterung 3. Die Schrauben befestigen auch die Hülsen 2 an der Halterung 3. Ein Draht, der in dem inneren Hohlraum der Hülse 2 eingeführt wurde, wird auf diese Weise an die Hülse geklemmt. Die kleinen Löcher an den Stirnseiten der Hülsen 2 zeigen die Durchtritte für die insgesamt sechs Drähte, die zwischen den Halteblöcken aufgespannt werden, siehe die Figur 3.

Diese Vorgänge sind exemplarisch für den rechten Teil der erfindungsgemäßen Vorrichtung beschrieben. Es versteht sich, dass in zusammengefügter Weise, jeweils drei Drähte von zwei Materialsorten in die rechte und die linke Drahthalterung alternierend wie beschrieben eingeführt und geklemmt werden.

Der Vorgang ist in Figur 3 gezeigt. Die Bezugszeichen 31.1, 31.2, 33, und 34 entsprechen den Bezugszeichen 1.1, 1.2, 3 und 4 der Figur 2 und es wird zur weiteren Erläuterung auf die Figur 2 verwiesen.

Die Drähte 31d, 31f und 31h bestehen aus Rhenium. Sie werden in die Hülsen 2d, 2f und 2h wie für Figur 2 dargestellt über die Löcher 3d, 3f und 3h geklemmt.

Die Drähte 31e, 31 g und 31 i bestehen aus Tantal. Sie werden in die Hülsen 2e, 2g und 2i wie für Figur 2 dargestellt über die Löcher 3e, 3g und 3i geklemmt.

Die Drähte werden zwischen die rechte und die linke Halterungen 33, 34 und wie für Figur 2 beschrieben, eingespannt. Die Drähte werden hierzu in die den Drähten entsprechenden Hülsen geschoben und mit den Halteblöcken 33, 34 verschraubt. Stromschienen 31.1 und 31.2 sind hierzu auf den Halteblöcken angeordnet. Über die Löcher in den Stromschienen wird wie für die Figur 2 beschrieben der Draht eingeklemmt und zwischen den Blöcken 33, 34 aufgespannt.

Über die Gaszuführungen 32a, 32b und 32c werden in Betrieb nacheinander entweder die Gassorten 1 oder 2 über Löcher 35 in die Kammer eingeleitet. Je eine Gaszuführung 32a-c versorgt je zwei Drähte mit Vorläufern bzw. ist zu zwei Drähten ausgerichtet, siehe Figur 3.

Die Klemme A ist an eine Gleichstromquelle angeschlossen (nicht dargestellt). Wenn über die Stromzuführung die Klemme A an Stromschiene 31.2 unter Strom gesetzt wird, so werden die Drähte 31i, 31 g und 31e, die in leitender Verbindung zur Stromschiene 31.2 stehen erhitzt. Über die Klemme A* wird der erste Stromkreis geschlossen.

Das Gasgemisch, das durch die Hohlröhre 32a-c geleitet wird, wird durch die erhitzten Rheniumdrähte fragmentiert.

Die Stromzuführung an die Klemme A wird unterbrochen und die Gaszufuhr gestoppt.

Dann wird die Klemme B unter Strom gesetzt. Wenn über die Stromzuführung die Klemme B an Stromschiene 31.1 unter Strom gesetzt wird, werden die Drähte 31d, 31 f und 31 h, die in leitender Verbindung zur Stromschiene 31.1 stehen erhitzt. Über die Klemme B* wird der zweite Stromkreis geschlossen.

Das Gasgemisch, das durch die Hohlröhre 32a-c geleitet wird, wird durch die Tantaldrähte fragmentiert.

Bei Betrieb der Rheniumdrähte ruhen also die Tantaldrähte bzw. werden nicht erhitzt und umgekehrt.

Über die Löcher 4m und 4n, die in der Figur 2 gezeigt sind, wird die zusammengebaute Drahthalterung auf Flansche 10 der Kammer wie in Figur 1 gezeigt, aufgeschraubt.

Ein Ausführungsbeispiel zur Herstellung von µc-Si:H und µc-SiC:H Schichten mit dem neuen HWCVD Drahthalter wird nachfolgend beschrieben.

Die Depositionen für den Test des Drahthalters für abwechselnde Herstellung von µc-Si:H und µc-SiC:H mit dem HWCVD Verfahren ohne Wechsel der Drahtmaterialien zwischen den Depositionen erfolgen in einer HWCVD Depositionsanlage mit Load-Lock Kammer. Die jeweils 10x10 cm² großen Glassubstrate werden durch das Load-Lock eingeschleust. Für die Weiterprozessierung der µc-SiC:H Schichten zu Solarzellen werden teilweise mit geätztem ZnO beschichtete Glassubstrate benutzt. Für die Untersuchung von Einzelschichten mit Infrarot-Spektroskopie werden auch Si-Wafer als Substrat benutzt

Im Drahthalter befinden sich jeweils drei parallel geschaltete Rheniumdrähte (für µc-SiC:H) und Tantaldrähte (für µc-Si:H) Deposition. Die unterschiedlichen Drahtmaterialien können separat angesteuert, das heißt mit Spannung versorgt werden.

Für die µc-Si:H Deposition werden die folgenden Prozessbedingungen eingestellt:

Substrattemperatur: 180°C; Temperatur der Tantaldrähte: 1900 - 2000 °C; Prozessgase: Silan in einer Verdünnung von 2-10% in Wasserstoff; Gasfluss total: 100 sccm; Prozessdruck: 0,06 hPa.

Für die µc-SiC:H Deposition werden die folgenden Prozessbedingungen eingestellt:

Substrattemperatur: 220°C; Temperatur der Rheniumdrähte: 1700 - 1800 °C; Prozessgase: Monomethylsilan in einer Verdünnung von 0,3% in Wasserstoff; Gasfluss total: 100 sccm; Prozessdruck: 0,75 hPa.

Die Depositionsabfolgen und -zeiten sind in der Tabelle gezeigt:

| Material | 1.) Re | 2.) Ta | 3.) Re | 4.) Ta | 5.) Re |
|---|---|---|---|---|---|
| Depositionszeiten insgesamt (Stunden) | 19 | 6 | 24 | 12 | 3 |

Die angegebenen mehrmaligen Wechsel der Drahtmaterialien führten zu keinen erkennbaren Schädigungen der Drahtmaterialien. Die akkumulierten Schichtdicken sind etwa 5 µm für µc-Si:H und etwa 3 µm für µc-SiC:H.

Die Qualität der µc-Si:H Schichten wurde durch elektrische Hell- und Dunkelleitfähigkeitsmessungen, Messungen des Wasserstoffgehalts und der Wasserstoffbindungsstruktur mit Infrarotspektroskopie und optische Absorption untersucht. Die Schichten zeigen die typischen Merkmale für gute elektrooptische Qualität, wie sie auch mit Drahthaltern mit nur einem Drahtmaterial hergestellt werden

Die Qualität der µc-SiC:H Schichten wurden durch den Einbau dieser Schichten in Solarzellen mit µc-Si:H Absorberschichten untersucht. Die mit dem Doppeldrahthalter hergestellten µcSiC:H Fensterschichten resultieren in Solarzellen mit hoher Qualität, wie sie auch bei Verwendung eines Drahthalters mit nur einem Drahtmaterial erzielt werden.

## Patentansprüche

1. Heißdrahtverfahren zur Abscheidung von Halbleiter-Material auf einem Substrat in einer Abscheidungskammer, bei dem mindestens zwei Drähte an ihren Enden in eine Drahthalterung geklemmt werden und durch Stromzufuhr erhitzt werden,
**dadurch gekennzeichnet, dass**
an Drähten aus verschiedenem Material zeitlich nacheinander eine Spannung zur Erzeugung eines elektrischen Stromflusses angelegt wird, so dass eine der Anzahl der nacheinander erhitzten Drahtmaterialien entsprechende Anzahl an verschiedenen Halbleitern nacheinander auf dem Substrat abgeschieden werden können ohne die Kammer zu öffnen.

2. Verfahren nach vorherigem Anspruch
**gekennzeichnet durch**
Wahl einer Drahthalterung, die elektrisch voneinander isolierte Stromzuführungen für die verschiedenen Drahtmaterialien aufweist.

3. Verfahren nach einem der vorhergehenden Ansprüche,
**dadurch gekennzeichnet, dass**
mehrere Drähte aus gleichem Material durch die Verteilung einer Stromzuführung gleichzeitig erhitzt werden.

4. Verfahren nach einem der vorherigen Ansprüche,
**gekennzeichnet durch**
Wahl von Rhenium und Tantal als Material der mindestens zwei verschiedenen Drähte.

5. Verfahren nach vorherigem Anspruch
**dadurch gekennzeichnet, dass**
abwechselnd µc-Si:H mit dem Tantaldraht und µc-SiC:H mit dem Rheniumdraht abgeschieden wird.

6. Vorrichtung zur Durchführung eines Heißdrahtverfahrens nach einem der vorhergehenden Ansprüche, umfassend
eine Drahthalterung für die Aufnahme mindestens zweier verschiedener Drähte, wobei die beiden Drähte aus verschiedenem Material an jeweils einen unterschiedlichen Stromkreis angebunden sind.

7. Vorrichtung nach vorherigem Anspruch
**gekennzeichnet dadurch, dass**
die Drahthalterung zwei Halteblöcke für die Aufnahme der Enden von parallel zueinander ausgerichteten Drähten aufweist.

8. Vorrichtung nach einem der vorhergehenden zwei Ansprüche,
**gekennzeichnet durch**
Halteblöcke aus Keramik, insbesondere aus Macor™ oder Al₂O₃.

9. Vorrichtung nach einem der vorhergehenden drei Ansprüche,
**dadurch gekennzeichnet, dass**
auf jedem Halteblock der Drahthalterung mindestens zwei Strom leitende Schienen als Stromzuführung angeordnet sind, die mit der Spannungsquelle und den Drähten in elektrischem Kontakt stehen.

10. Vorrichtung nach vorherigern Anspruch
**dadurch gekennzeichnet, dass**
eine Strom leitende Schiene auf dem Halteblock mehrere Drähte aus identischem Material kontaktiert.

11. Vorrichtung nach einem der vorhergehenden zwei Ansprüche,
**dadurch gekennzeichnet, dass**
die Drahthalterung entlang der Drähte Gaszuführungen aufweist, durch die in Betrieb der Heißdraht (HWCVD)-Vorrichtung Vorläuferverbindungen an die Drähte geführt werden.

## Claims

1. Hot-wire method for depositing semi-conductor material on a substrate in a deposition chamber, in which at least two wires are clamped at their ends into a wire holder and are heated by supplying a current, **characterised in that** a voltage for generating an electrical current flow is applied in succession to wires made of different materials so that a number of different semi-conductors corresponding to the number of wire materials heated one after the other can be deposited one after the other on the substrate without opening the chamber.

2. Method according to the preceding claim, **characterised by** the selection of a wire holder comprising current supply elements for the different wire materials electrically insulated from one another.

3. Method according to one of the preceding claims, **characterised in that** several wires made of the same material are heated simultaneously by distributing a current supply.

4. Method according to one of the preceding claims, **characterised by** the selection of rhenium and tantalum as the materials for the at least two different wires.

5. Method according to the preceding claim, **characterised in that** µc-Si:H and µc-SiC:H are deposited in alternation using the tantalum and rhenium wires respectively.

6. Device for carrying out a hot-wire method according to one of the preceding claims, including a wire holder for receiving at least two different wires, wherein the two wires made of different materials are each connected to a different circuit.

7. Device according to the preceding claim, **characterised in that** the wire holder comprises two holding blocks for receiving the ends of wires oriented parallel to one another.

8. Device according to one of the preceding two claims, **characterised by** holding blocks made of ceramic material, particularly of Macor™ or Al₂O₃.

9. Device according to one of the preceding three claims, **characterised in that** at least two current-conducting rails are arranged on each holding block of the wire holder as current supply elements in electrical contact with the voltage source and the wires.

10. Device according to the preceding claim, **characterised in that** a current-conducting rail on the holding block contacts several wires made of identical material.

11. Device according to one of the preceding two claims, **characterised in that** the wire holder is provided along the wires with gas supply lines through which precursor compounds are conducted to the wires during operation of the hot-wire (HWCVD) device.

## Revendications

1. Procédé à fil chaud pour le dépôt de matériau semi-conducteur sur un substrat dans une chambre de dépôt, dans lequel au moins deux fils sont pincés à leurs extrémités dans un support de fils et sont chauffés par alimentation en courant,
**caractérisé en ce que**,
sur des fils en matériau différent, une tension est appliquée successivement dans le temps pour la génération d'un flux de courant électrique de sorte qu'un nombre de semi-conducteurs différents correspondant au nombre de matériaux de fil chauffés successivement puisse être déposé successivement sur le substrat sans ouvrir la chambre.

2. Procédé selon la revendication précédente,
**caractérisé par**
le choix d'un support de fils, lequel présente des alimentations en courant isolées électriquement les unes des autres pour les différents matériaux de fil.

3. Procédé selon l'une des revendications précédentes,
**caractérisé en ce que**
plusieurs fils en un matériau identique sont chauffés simultanément grâce à la répartition d'une alimentation en courant.

4. Procédé selon l'une des revendications précédentes,
**caractérisé par**
le choix de rhénium et de tantale en tant que matériau des au moins deux différents fils.

5. Procédé selon la revendication précédente,
**caractérisé en ce que**
l'on dépose tour à tour du µc-Si:H avec le fil de tantale, et du µc-SiC:H avec le fil de rhénium.

6. Dispositif pour la mise en oeuvre d'un procédé à fil chaud selon l'une des revendications précédentes, comprenant
un support de fils pour la réception d'au moins deux différents fils, les deux fils en matériau différent étant raccordés respectivement à un circuit électrique différent.

7. Dispositif selon la revendication précédente,
**caractérisé en ce que**
le support de fils présente deux blocs de maintien pour la réception des extrémités de fils orientés parallèlement les uns par rapport aux autres.

8. Dispositif selon l'une des deux revendications précédentes,
**caractérisé par**
des blocs de maintien en céramique, en particulier en Macor^{™} ou en al₂O₃.

9. Dispositif selon l'une des trois revendications précédentes,
**caractérisé en ce que**,
sur chaque bloc de maintien du support de fils, au moins deux rails électro-conducteurs sont disposés en guise d'alimentation en courant, lesquels sont en contact électrique avec la source de tension et les fils.

10. Dispositif selon la revendication précédente,
**caractérisé en ce que**
un rail électro-conducteur sur le bloc de maintien entre en contact avec plusieurs fils en matériau identique.

11. Dispositif selon l'une des deux revendications précédentes,
**caractérisé en ce que**
le support de fils présente des arrivées de gaz le long des fils, grâce auxquelles, lors du fonctionnement du dispositif de dépôt de vapeur chimique au fil chaud (HWCVD), des composés précurseurs sont amenés au niveau des fils.
